(19) Europäisches Patentamt
European Patent Office
Office européen des brevets

(11) **EP 2 803 480 B1**

(12) **EUROPEAN PATENT SPECIFICATION**

(45) Date of publication and mention
of the grant of the patent:
**15.08.2018 Bulletin 2018/33**

(21) Application number: **14166614.9**

(22) Date of filing: **30.04.2014**

(51) Int Cl.:
*B32B 15/00* (2006.01)     *H01J 37/32* (2006.01)
*B23K 20/14* (2006.01)     *H01L 23/14* (2006.01)
*B32B 15/01* (2006.01)     *B23K 20/04* (2006.01)
*B23K 20/00* (2006.01)     *C04B 37/02* (2006.01)
*H01L 23/373* (2006.01)     *B23K 103/16* (2006.01)
*B21B 9/00* (2006.01)     *B21B 1/38* (2006.01)

(54) **Production method of multilayer clad material**

Herstellungsverfahren von mehrschichtigem Plattierungsmaterial

Procédé de production de matériau plaqué multicouche

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **17.05.2013 JP 2013104698**

(43) Date of publication of application:
**19.11.2014 Bulletin 2014/47**

(73) Proprietor: **Showa Denko K.K.
Tokyo 105-8518 (JP)**

(72) Inventor: **Otaki, Atsushi
Tochigi, 323-8678 (JP)**

(74) Representative: **Hoffmann Eitle
Patent- und Rechtsanwälte PartmbB
Arabellastraße 30
81925 München (DE)**

(56) References cited:
**EP-A1- 1 119 048        EP-A1- 1 342 564
WO-A1-2012/063638        JP-A- 2012 004 534
JP-A- 2012 227 356        US-A- 4 896 813
US-B1- 6 419 149**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

Printed by Jouve, 75001 PARIS (FR)

## Description

### TECHNICAL FIELD

The present invention relates to a method of producing a multilayer clad material which is preferably used as, for example, a multilayered material for insulating substrates used for heat dissipation, etc., of a semiconductor element.

In this specification, the term "multilayer" denotes a "multiple layer having three or more layers."

Further, in this specification, the term "nickel plate" is used so as to include a Ni plate and a Ni alloy plate, the term "titanium plate" is used so as to include a Ti plate and a Ti alloy plate, and the term "aluminum plate" is used so as to include an Al plate and an Al alloy plate. Further, in this specification, the term "metallic plate" is used so as to include metallic plates made of single metal and an alloy plate.

Further, in this specification, the term "plate" such as a nickel plate is used so as to include a plate, a sheet, a foil, etc., and those having a thickness of 4 $\mu$m to 10 mm are collectively called "plate."

Further, in this specification, the term "dissimilar metallic materials" are used so as to include metallic materials different in constituent metallic element (for example, one is a Ni plate and the other is a Ti plate).

### BACKGROUND ART

A semiconductor module such as a power semiconductor module, etc., is equipped with a head dissipation member (e.g., a heat sink, a cooler) for releasing heat generated from a semiconductor element by the operation of the semiconductor element. Further, in this semiconductor module, a heat dissipation insulating substrate for transmitting the heat generated by the semiconductor to the heat dissipation member is arranged between the semiconductor element and the heat dissipation member. This insulating substrate functions as a conductor thermally and as an insulating material electrically, and is concretely provided with a ceramic layer as an electric insulation layer and a metallic layer including a wiring layer (circuit layer) joined to one surface of the ceramic layer (see, e.g., Patent Documents 1 to 4). A semiconductor element is joined to a metallic layer of an insulating substrate by soldering.

As a layer constituting a metallic layer, in recent years, an aluminum layer made of Al or Al alloy is used. The reasons are that an aluminum layer is excellent in electric characteristics and thermal characteristics, and that using an aluminum layer enables weight saving as compared with a conventional insulating substrate using Cu and also enables production cost reduction of the insulating substrate.

Patent Document 1: Japanese Unexamined Laid-open Patent Application Publication No. 2004-328012
Patent Document 2: Japanese Unexamined Laid-open Patent Application Publication No. 2004-235503
Patent Document 3: Japanese Unexamined Laid-open Patent Application Publication No. 2006-303346
Patent Document 4: Japanese Unexamined Laid-open Patent Application Publication No. 2009-147123

Further related prior art may be found in JP 2012 004534 A and US 4,896,813 A. The first describing a heat radiation insulating substrate in which a ceramic layer, a first metallic layer disposed on one side of the ceramic layer and a second metallic layer disposed on the opposite side to the ceramic layer posing side of the first metallic layer and including nickel as an essential element adjoined and integrated in a laminating shape and capable of preventing problems such as warpage, cracking and peering of the insulating substrate. The latter disclosing a method for metals to be bonded, which are drawn from pay-off reels and passed around holding rollers which are grounded cathodes, wherein each roller is partially exposed in an etching chamber having an anode area is at least three times the exposed area of the cathode. Each chamber has an inert gas and is subjected to RF power, which by a magnetic field produced by fixed magnets in the holding roller produces a glow discharge plasma which etches the metal in the chamber. Etched surfaces of the strips are then rolled together in a vacuum and a temperature to 300° C at a rolling pressure sufficient to effect a thickness reduction from 0.1 to 30%.

### PROBLEMS TO BE SOLVED BY THE INVENTION

However, an aluminum layer is poor in solder joining property. Therefore, it is performed to form a Ni plated layer on a surface of an aluminum layer so that a semiconductor element can be joined thereto by soldering. In this case, however, an alloy layer poor in strength is formed at a joint interface between the aluminum layer and the Ni plated layer. As a result, by the thermal stress (thermal strain) generated by the cold heat cycle, there arise problems that cracks and/or separations readily occur in the alloy layer and deformation (unevenness) readily occurs on the surface of the Ni plated layer.

Under the circumstances, the present inventors have conceived a strategy of using a material as a wiring layer material in which a nickel layer made of Ni or Ni alloy having a surface on which a semiconductor element is joined, a titanium layer made of Ti or Ti alloy, and an aluminum layer made of Al or Al alloy are laminated in this order by a clad rolling method or a discharge plasma sintering method.

However, in the multilayer clad material obtained by a discharge plasma sintering method, joining can be performed regardless of the structural ratio of the thickness of each material at the time of performing multilayer cladding. However, there is a problem that the method is a small amount batch method, which is not suitable for a mass production, and therefore the production cost is expensive.

On the other hand, the multilayer clad material obtained by a clad rolling method is excellent in mass productivity. However, there is a problem that, in producing a multilayer (three or more layer) clad material, a layer to be arranged in the middle thereof has a limitation in the structural thickness ratio acceptable by the difference of the physical properties (strength, elongation, etc.) between the layer to be arranged in the middle and the material to be arranged on the outer side thereof. For example, there is a problem that if it is designed without paying attention to this limitation, the layer (titanium layer in the aforementioned multilayer clad material) arranged in the middle breaks or even if no breakage occurs, the thickness cannot be controlled to have a desired thickness with a high degree of accuracy. In cases where the thickness cannot be controlled to have a desired thickness with a high degree of accuracy, for example, desired thermal characteristics cannot be obtained.

Further, in a clad rolling method, it is required to perform a diffusion heat treatment to increase a joint strength of the joint interface. However, performing a heat treatment to a clad material in which two or more layers in which dissimilar metallic materials are joined causes curves and/or undulations in the material (especially, in a wide material, curves and/or undulations occur notably) due to the difference of raw material, which makes it difficult to roll up the clad material into a coil form. Especially, when a multilayer clad material having three or more layers is produced by a clad rolling method, curves and/or undulations occur notably in the material, which prevents the multilayer clad material from being rolled up into a coil form. For this reason, it is practically difficult to produce it.

The present invention was made in view of the aforementioned technical background, and aims to provide a production method of a multilayer clad material capable of mass-producing a multilayer clad material of three or more layers at low cost, wherein the multilayer clad material has no curve, a thickness of each constituent layer is controlled with a high degree of accuracy and no crack and/or separation occurs in the constituent layer even if a cold heat is applied.

## MEANS FOR SOLVING THE PROBLEMS

The aforementioned objects are attained by the method according to claim 1 and its dependent claims.

In the production method according to an embodiment, since the nickel plate and the titanium plate are superposed and clad rolled at a rolling reduction of 25 % to 85 % in the rolling step, a laminated plate in which the nickel plate and the titanium plate are laminated can be obtained at low cost.

Thereafter, in vacuum, at least the surface of the titanium plate of the laminated plate and at least the joint scheduled surface of the aluminum plate are subjected to plasma etching as a surface activation treatment. Therefore, oxides, absorbed substances, etc., on these joint scheduled surfaces can be removed to expose the cleaned surfaces, which in turn can improve the joint strength.

In the cold pressure welding step, in vacuum, the laminated plate and the aluminum plate are superposed, and these plates are cold pressure welded by and between a pair of pressure rolls so that the rolling reduction becomes as low as 0.1 % to 15 %. Therefore, even in cases where, for example, the thickness of the aluminum plate and the thickness of the titanium plate differ significantly (e.g., the thickness of the aluminum plate is over 2.0 times or less than 0.5 times the thickness of the titanium plate), it is possible to obtain a multilayer clad material in which the thickness of the thinner metallic plate is controlled with a high degree of accuracy. Further, the cold pressure welding is performed so that the rolling reduction becomes as low as 0.1% to 15 %. Therefore, there are advantages that the joint interface of the aluminum plate and the titanium plate becomes excellent in flatness and no alloy layer (the alloy layer causes negative effects on mechanical characteristics such as joint strength, etc. , and/or electric characteristics) is formed at the joint interface of the aluminum plate and the titanium plate. Further, the cold pressure welding is performed so that the rolling reduction becomes as low as 0.1 % to 15 % and no diffusion heat treatment is required thereafter (a diffusion heat treatment can be omitted). Therefore, even in the case of using a wide width material, a multilayer clad material with no curve can be obtained.

In the production method according to an embodiment, although the thickness of the aluminum plate is over 2.0 times or less than 0.5 times the thickness of the titanium plate and the thicknesses of both the plates differ greatly, it is possible to obtain a multilayer clad material in which the thickness of the thinner metallic plate is controlled with a high degree of accuracy.

In the production method according to an embodiment, the thickness of the nickel plate is 10 $\mu$m to 100 $\mu$m, the thickness of the titanium plate is 5 $\mu$m to 30 $\mu$m, and the thickness of the aluminum plate is within a range of over 60 $\mu$m to 10 mm or less. Although at least the thickness of the titanium plate is thin as mentioned above, it is possible to obtain a multilayer clad material in which the thicknesses of these titanium plate, nickel plate and aluminum plate are controlled with a high degree of accuracy.

In the production method according to an embodiment, in the first rolling step, the nickel plate and the titanium plate are superposed and clad rolled at a rolling reduction of 25 % to 85 %. Therefore, it is possible to obtain a first laminated plate in which the nickel plate and the titanium plate are laminated at low cost.

Further, in the second rolling step, the aluminum plate and the brazing plate are superposed and clad rolled at a rolling reduction of 25 % to 85 %. Therefore, it is possible to obtain a second laminated plate in which the aluminum plate and the brazing plate are laminated at low cost.

Thereafter, in vacuum, at least the surface of the titanium plate of the first laminated plate and at least the surface of the aluminum plate of the second laminated plate are subjected to a surface activation treatment, it is possible to remove oxides, absorbed substances, etc., on these joint scheduled surfaces to expose the cleaned surfaces, which in turn can improve the joint strength.

In the cold pressure welding step, in vacuum, the first laminated plate and the second laminated plate are superposed and both plates are cold pressure welded by and between the pair of pressure rolls so that the rolling reduction becomes as low as 0.1 % to 15 %. Therefore, for example, even in cases where the thickness of the aluminum plate and the thickness of the titanium plate differ greatly (for example, the thickness of the aluminum plate is over 2.0 times or less than 0.5 times the thickness of the titanium plate), it is possible to obtain a multilayer clad material in which the thickness of the thinner metallic plate is controlled with a high degree of accuracy. Further, the cold pressure welding is performed so that the rolling reduction becomes as low as 0.1% to 15 %. Therefore, there are advantages that the joint interface of the aluminum plate and the titanium plate becomes excellent in flatness and no alloy layer (the alloy layer causes negative effects on mechanical characteristics such as joint strength, etc., and/or electric characteristics) is formed at the joint interface of the aluminum plate and the titanium plate . Further, the cold pressure welding is performed so that the rolling reduction becomes as low as 0.1 % to 15 % and no diffusion heat treatment is required thereafter (the treatment can be omitted), and therefore even in the case of using a wide width material, a multilayer clad material with no curve can be obtained.

In the production method according to an embodiment, although the thickness of the aluminum plate is over 2.0 times or less than 0.5 times the thickness of the titanium plate and the thicknesses of both the plates differ greatly, it is possible to obtain a multilayer clad material in which the thickness of the thinner metallic plate is controlled with a high degree of accuracy.

In the production method according to an embodiment, the thickness of the nickel plate is 10 $\mu$m to 100 $\mu$m, the thickness of the titanium plate is 5 $\mu$m to 30 $\mu$m, the thickness of the aluminum plate is within the range of over 60 $\mu$m to 10 mm or less, the thickness of the brazing plate is 10 $\mu$m to 60 $\mu$m, and at least the thickness of the titanium plate is thin. However, it is possible to obtain a multilayer clad material in which the thicknesses of these titanium plate, nickel plate, aluminum plate and brazing plate are controlled with a high degree of accuracy.

In the production method according to an embodiment, since the surface activation treatment is performed by plasma etching processing, it is possible to remove oxides, absorbed substances, etc., on the joint scheduled surfaces to expose the cleaned surfaces, which in turn can further improve the joint strength.

In the production method according to an embodiment, since the temperature of the pressing rolls at the time of the cold pressure welding in the cold pressure welding step is set within the range of 10 °C to 80 °C, it is possible to obtain a multilayer clad material in which the thickness of the thinner metallic plate is controlled with a higher degree of accuracy.

In the production method according to an embodiment, in the rolling step, since the clad rolling is performed at the rolling reduction of 45 % to 65 %, it is possible to stably produce a multilayer clad material without imposing excessive loads on the facility (while controlling the facility cost without requiring large facility capacity).

**BRIEF DESCRIPTION OF THE DRAWINGS**

Fig. 1 is a cross-sectional view showing one embodiment of a multilayer clad material produced by a first production method according to the present invention.
Fig. 2 is a cross-sectional view showing one embodiment of a multilayer clad material produced by a second production method according to the present invention.
Fig. 3 is a schematic side view showing an example of a production apparatus used in a surface activation treatment step and a cold pressure welding step in a state in which a first production method is being performed.
Fig. 4 is a schematic side view showing an example of a production apparatus used in a surface activation treatment step and a cold pressure welding step in a state in which a second production method is being performed.
Fig. 5 is a cross-sectional view showing an example of an insulating substrate constituted using the multilayer clad material of Fig. 2.

Fig. 6 is a schematic cross-sectional view showing an example of a cooler integrated insulating substrate constituted using the multilayer clad material of Fig. 1 in an exploded state before lamination.

Fig. 7 is a schematic cross-sectional view showing an example of a cooler integrated insulating substrate constituted using the multilayer clad material of Fig. 2 in an exploded state before lamination.

Fig. 8 is a schematic cross-sectional view showing another example of a cooler integrated insulating substrate constituted using the multilayer clad material of Fig. 2 in an exploded state before lamination.

Fig. 9 is a schematic side view showing an example of the semiconductor module.

## EMBODIMENTS FOR CARRYING OUT THE INVENTION

In the following paragraphs, some preferred embodiments of the invention will be described.

### [First Production method]

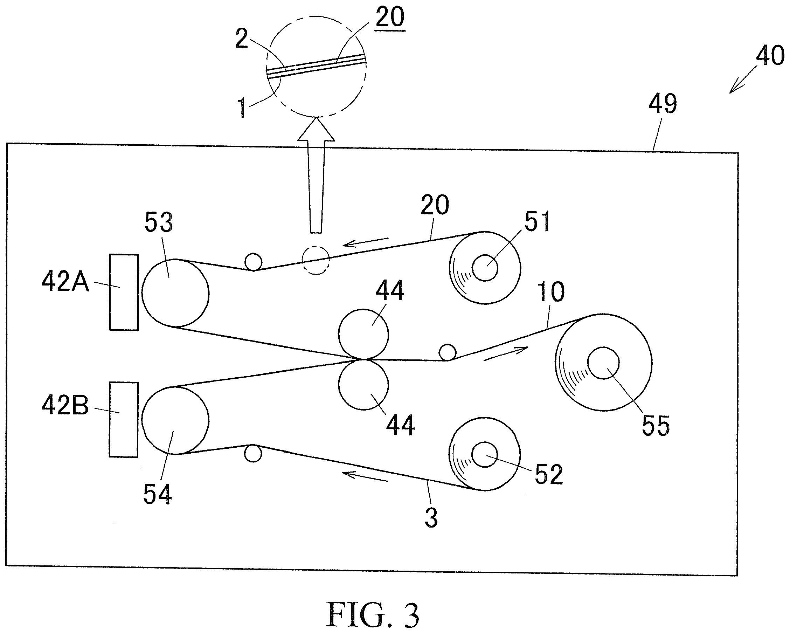

A first production method of a multilayer clad material according to the present invention will be explained with reference to Fig. 3.

### (Rolling Step)

By placing a first metallic plate 1 and a second metallic plate 2 made of dissimilar metallic materials or same metallic material and clad rolling them at a rolling reduction of 25 % to 85 %, a laminated plate 20 is obtained. A nickel plate is used as the first metallic plate 1 and a titanium plate is used as the second metallic plate 2. That is by superposing the nickel plate 1 and the titanium plate 2 and clad rolling them at the rolling reduction of 25 % to 85 %, a laminated plate 20 is obtained. The obtained laminated plate 20 is rolled up on a first supply roll 51.

In this rolling step, the first metallic plate 1 and the second metallic plate 2 are superposed and clad rolled, and therefore the laminated plate 20 in which the first metallic plate 1 and the second metallic plate 2 are laminated can be obtained at low cost.

The clad rolling in the rolling step is performed by cold clad rolling. In this case, since it is not especially required to heat the material (metallic plate), the productivity can be improved. The temperature of the reduction roll at the time of the cold clad rolling is set within a range of 10 °C to 120 °C.

The "rolling reduction" is a value obtained by the following calculation formula:

$$\text{rolling reduction (\%)} = \{(M-N) \; / \; M\} \times 100,$$

where "M" ($\mu$m) is a total of the thickness of the first metallic plate and the thickness of the second metallic plate before clad rolling, and "N" ($\mu$m) is a thickness of the laminated plate 20 obtained by the clad rolling.

Before the rolling step, it is preferable to preliminarily perform mechanical polishing of the joint scheduled surface of the first metallic plate 1 and the joint scheduled surface of the second metallic plate 2. As the mechanical polishing, a method of polishing with a wire brush, for example, is exemplified. But the method is not specifically limited as long as it can mechanically remove a surface oxide layer of the joint scheduled surface. By performing such mechanical polishing (providing a mechanical polishing step), even by the clad rolling at the rolling reduction of, e.g., 25 % to 70 %, joining with sufficient joint strength can be attained.

Further, after the rolling step but before the subsequent surface activation treatment step, the laminated plate 20 obtained by the clad rolling can be subjected to a diffusion heat treatment at a heat treatment temperature of 500 °C to 700 °C. By performing such diffusion heat treatment, the joint strength of the first metallic plate 1 and the second metallic plate 2 can be improved.

### (Surface Activation Treatment Step)

Next, as shown in Fig. 3, the first supply roll 51 on which the laminated plate 20 is wound is arranged in a vacuum chamber 49 of the production apparatus 40, and the other second supply roll 52 on which a third metallic plate 3 is wound is arranged in the vacuum chamber 49. As the third metallic plate 3 an aluminum plate is used.

The vacuum chamber 49 is configured so that the interior space can be made into a vacuum state by a not-illustrated vacuum apparatus. In the vacuum chamber 49, a first electrode roll 53, a surface activation treatment apparatus 42A arranged apart from the first electrode roll 53 at a position close to the first electrode roll 53, a second electrode roll 54, a surface activation treatment apparatus 42B arranged apart from the second electrode roll 54 at a position closed to the second electrode roll 54, a pair of pressure rolls 44 and 44, and a wind-up roll 55 are arranged. The surface activation treatment apparatus 42A is configured to perform plasma etching processing of the surface of the metallic plate fitted on the outer peripheral surface of the first electrode roll 53 by applying a high-frequency voltage having a frequency of 10 MHz to 50 MHz between an electrode in the apparatus 42A and the first electrode roll 53 to irradiate plasma onto the surface of the metallic plate. In the same manner, the surface activation treatment apparatus 42B is configured to perform plasma etching processing of the surface of the metallic plate fitted on the outer peripheral surface of the second electrode roll 54 by applying a high-frequency voltage having a frequency of 10 MHz to 50 MHz between an electrode in the apparatus 42B and the second electrode roll 54 to irradiate plasma onto the surface of the metallic plate.

Next, the inside of the vacuum chamber 49 is maintained in a vacuum state. It is preferable that the degree of vacuum in the vacuum chamber 49 is set to $1 \times 10^{-4}$ Pa to 1 Pa. Further, it is also preferable that the inside of the vacuum chamber 49 is filled with inert gas such as nitrogen, argon, etc., into an inert gas atmosphere and then the degree of vacuum is set to $1 \times 10^{-4}$ Pa to 1 Pa by raising the degree of vacuum.

In the vacuum chamber 49 which is in a vacuum state, the laminated plate 20 unwound from the first supply roll 51 is brought into contact with the outer peripheral surface of the first electrode roll 53 along the outer peripheral surface thereof, plasma is irradiated from the surface activation treatment apparatus 42A onto the surface of the second metallic plate (e.g., titanium plate) 2 of the laminated plate 20 in contact with the first electrode roll 53, and thereafter the laminated plate 20 is fed between a pair of pressure rolls 44 and 44 (see Fig. 3). By the plasma etching processing, it is possible to remove oxides, absorbed substances, etc., on the surface of the second metallic plate (e.g., titanium plate) 2 which is a joint scheduled surface of the laminated plate 20 and expose the cleaned surface.

At the same time, in the vacuum chamber 49 which is in a vacuum state, the third metallic plate (e.g., aluminum plate) 3 unwound from the second supply roll 52 is brought into contact with the outer peripheral surface of the second electrode roll 54 along the outer peripheral surface thereof, plasma is irradiated from the surface activation treatment apparatus 42B onto the surface (joint scheduled surface) of the third metallic plate (e.g., aluminum plate) 3 in contact with the second electrode roll 54, and thereafter the third metallic plate (e.g., aluminum plate) 3 is fed between the pair of pressure rolls 44 and 44 (see Fig. 3). By the plasma etching processing, it is possible to remove oxides, absorbed substances, etc., on the joint scheduled surface of the third metallic plate (e.g., aluminum plate) 3 and expose the cleaned surface.

**(Cold Pressure Welding Step)**

Subsequently, in the vacuum chamber 49 which is in a vacuum state, the laminated plate 20 and the third metallic plate 3 (e.g., aluminum plate) are superposed so that the surface of the second metallic plate (e.g., titanium plate) 2 which is a joint scheduled surface of the laminated plate 20 and the joint scheduled surface (one surface) of the third metallic plate (e.g., aluminum plate) 3 are brought into contact with each other and cold pressure welded by and between the pair of pressure rolls 44 and 44 so that the rolling reduction becomes as low as 0.1 % to 15 % (see Fig. 3) .

Thereafter, in the vacuum chamber 49 which is in a vacuum state, the multilayer clad material 10 obtained by the cold pressure welding is wound up on the wind-up roll 55 (see Fig. 3) .

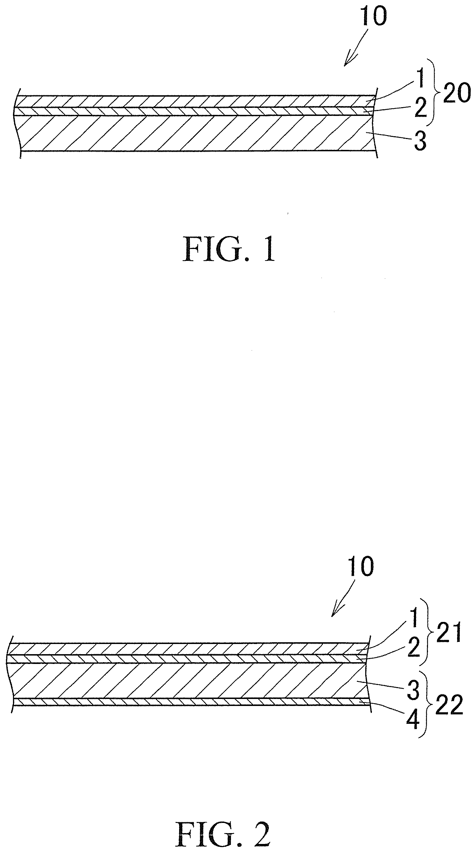

The obtained multilayer clad material 10, as shown in Fig. 1, has a three-layer laminated structure in which the first metallic plate (e.g., nickel plate) 1 is laminated on one surface of the second metallic plate (e.g., titanium plate) 2 and the third metallic plate (e.g. , aluminum plate) 3 is laminated on the other surface of the second metallic plate (e.g., titanium plate) 2.

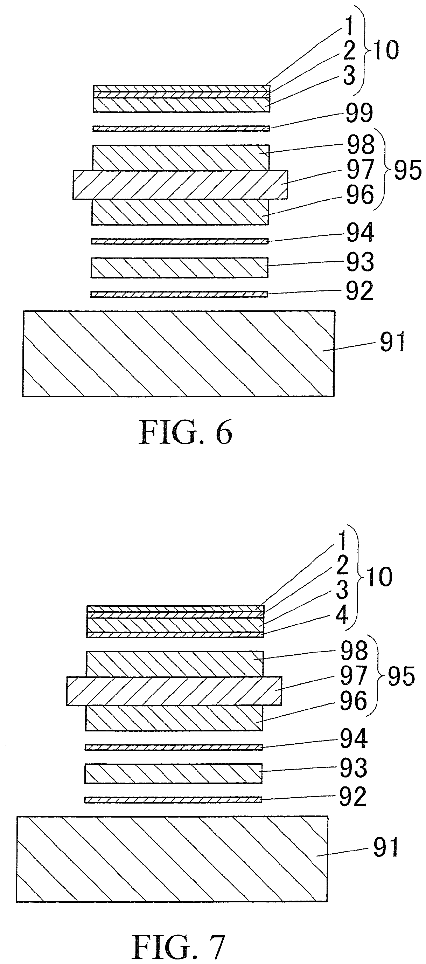

The multilayer clad material 10 having the three-layer laminated structure of the nickel plate 1/ titanium plate 2 / aluminum plate 3 can be used by being brazed to the semiconductor element joining surface side of a DBA substrate (cooler integrated insulating substrate) 95 with a brazing foil 99 (see Fig. 6) or by being brazed directly to a ceramic plate. Fig. 6 is a schematic cross-sectional view showing an example of a cooler integrated insulating substrate in an exploded state before lamination. In Fig. 6, the reference symbol "91" denotes an aluminum plate as a heat dissipation member, "92" denotes an aluminum brazing foil, "93" denotes an aluminum punching plate, "94" denotes an aluminum brazing foil, "95" denotes a DBA (Al layer 96 / AlN layer (aluminum nitride layer) 97 / Al layer 98), and "99" denotes an aluminum brazing foil.

In joining using a brazing foil separately as mentioned above, since a brazing material is hard and not suitable for rolling, a special foil rolling apparatus will be required to make a brazing material into a foil having a thickness of 250 $\mu$m or less, and that the yield is not good enough. Further, a brazing foil is not good in handling characteristics. Under the circumstances, it is preferable to obtain a multilayer clad material 10 having a four-layer laminated structure of nickel plate 1 / titanium plate 2 / aluminum plate 3 / aluminum brazing plate 4 by applying a second production method which will be detailed later.

In the aforementioned cold pressure welding step, the rolling reduction is set to 0.1% to 15 %. By setting the rolling reduction to the range, it is possible to further improve the flatness of the joint interface of the third metallic plate and the second metallic plate, and also possible to obtain a multilayer clad material in which no alloy layer is formed at the joint interface of the third metallic plate and the second metallic plate and the thickness of the thinner metallic plate is controlled with a higher degree of accuracy. When the rolling reduction is less than 0.1 %, a sufficient joint strength cannot be obtained between the third metallic plate and the second metallic plate. Further, when the rolling reduction exceeds 15 %, there arise problems that the flatness of the joint interface cannot be obtained and cracks occur at the joint interface in the case of a combined metallic material forming a brittle alloy layer. Among other things, it is preferable that the rolling reduction is set to 0.1 % to 10 %, more preferably 0.1 % to 5.0 %.

The "rolling reduction" is a value obtained by the following calculation formula:

$$\text{rolling reduction (\%)} = \{(X-Y) \: / \: X\} \times 100,$$

where "X" (μm) is a total of the thickness (a total of the thickness of the laminated plate and the thickness of the third metallic plate) of the metallic plates to be subjected to cold pressure welding before being cold pressure welded by and between the pressure rolls 44 and 44, and "Y" (μm) is a thickness of the multilayer clad material 10 obtained by the clad rolling.

It is preferable that the temperature of the pressure rolls 44 at the time of executing the cold pressure welding in the cold pressure welding step is set within a range of 10 °C to 80 °C, and in this case, it is possible to obtain a multilayer clad material 10 in which the thickness of the thinner metallic plate is controlled with a higher degree of accuracy.

In the first production method, like Example 1 which will be explained later, the first metallic plate, second metallic plate and third metallic plate are structured such that these three plates are made of dissimilar metallic materials, which is a major example but not limited to it.

According to the aforementioned first production method, the surface activation treatment is executed before the cold pressure welding and therefore oxides, absorbed substances, etc. , on the joint scheduled surfaces are removed by the surface activation treatment to expose the cleaned surfaces, in the following cold pressure welding step, sufficient joint strength can be secured even at a low rolling reduction (0.1 % to 15 %) . Therefore, in the first production method, no diffusion heat treatment (to improve the joint strength) is required after the cold pressure welding step, and therefore a diffusion heat treatment (normally, a heat treatment at 300 °C or above) is not executed after the cold pressure welding step. Therefore, according to the first production method, even in the case of using a wide width material, a multilayer clad material with no curve can be obtained.

[Second Production Method]

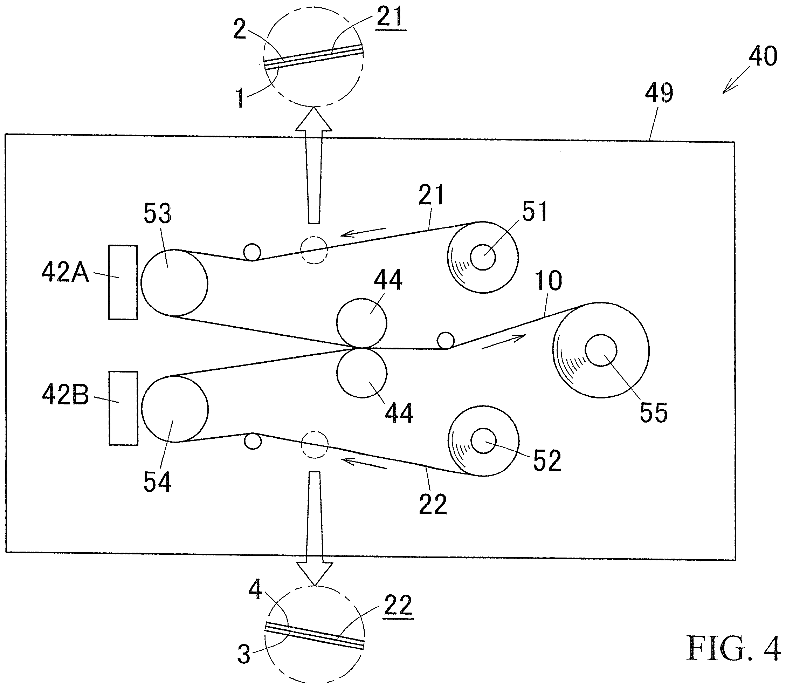

Next, a second production method of a multilayer clad material according to the present invention will be explained with reference to Fig. 4.

(First Rolling Step)

By superposing a first metallic plate 1 and a second metallic plate 2 made of dissimilar metallic materials and clad rolling them at a rolling reduction of 25 % to 85 %, a first laminated plate 21 is obtained. A nickel plate is used as the first metallic plate 1 and a titanium plate is used as the second metallic plate 2. That is by superposing the nickel plate 1 and the titanium plate 2 and clad rolling them at the rolling reduction of 25 % to 85 %, the first laminated plate 21 is obtained. The obtained first laminated plate 21 is rolled up on a first supply roll 51.

In this first rolling step, the first metallic plate 1 and the second metallic plate 2 are superposed and clad rolled, and therefore the first laminated plate 21 in which the first metallic plate 1 and the second metallic plate 2 are laminated can be obtained at low cost.

The clad rolling in the first rolling step is preferably performed by cold clad rolling. In this case, since it is not especially required to heat the material (metallic plate), the productivity can be improved. The temperature of the reduction roll at the time of the cold clad rolling is preferably set within a range of 10 °C to 120 °C.

The "rolling reduction" is a value obtained by the following calculation formula:

$$\text{rolling reduction (\%)} = \{(C-D) \: / \: C\} \times 100,$$

where "C" (μm) is a total of the thickness of the first metallic plate and the thickness of the second metallic plate before clad rolling, and "D" (μm) is a thickness of the first laminated plate 21 obtained by the clad rolling.

Before the first rolling step, it is preferable to preliminarily perform mechanical polishing of the joint scheduled surface of the first metallic plate 1 and the joint scheduled surface of the second metallic plate 2. As the mechanical polishing, a method of polishing with a wire brush, for example, is exemplified, but the method is not specifically limited as long as it can mechanically remove a surface oxide layer of the joint scheduled surface. By performing such mechanical polishing (providing a mechanical polishing step), even by the clad rolling at the rolling reduction of, e.g., 25 % to 70 %, joining with sufficient joint strength can be attained.

Further, after the first rolling step but before the subsequent surface activation treatment step, the first laminated plate 21 obtained by the clad rolling can be subjected to a diffusion heat treatment at a heat treatment temperature of 500 °C to 700 °C. By performing such diffusion heat treatment, the joint strength of the first metallic plate 1 and the second metallic plate 2 can be improved.

**(Second Rolling Step)**

By superposing a third metallic plate 3 and a fourth metallic plate 4 made of dissimilar metallic materials and clad rolling them at a rolling reduction of 25 % to 85 %, a second laminated plate 22 is obtained. An aluminum plate is used as the third metallic plate 3 and an aluminum brazing plate is used as the fourth metallic plate 4. That is by superposing the aluminum plate 3 and the aluminum brazing plate 4 and clad rolling them at the rolling reduction of 25 % to 85 %, the second laminated plate 22 is obtained. The obtained second laminated plate 22 is rolled up on a second supply roll 52.

In this second rolling step, the third metallic plate 3 and the fourth metallic plate 4 are superposed and clad rolled, and therefore the second laminated plate 22 in which the third metallic plate 3 and the fourth metallic plate 4 are laminated can be obtained at low cost.

The clad rolling in the second rolling step is performed by cold clad rolling. In this case, since it is not especially required to heat the material (metallic plate), the productivity can be improved. The temperature of the reduction roll at the time of the cold clad rolling is set within a range of 10 °C to 120 °C.

The "rolling reduction" is a value obtained by the following calculation formula:

$$\text{rolling reduction (\%)} = \{(E - F) / E\} \times 100,$$

where "E" ($\mu$m) is a total of the thickness of the third metallic plate and the thickness of the fourth metallic plate before clad rolling, and "F" ($\mu$m) is a thickness of the second laminated plate 22 obtained by the clad rolling.

Before the second rolling step, it is preferable to preliminarily perform mechanical polishing of the joint scheduled surface of the third metallic plate 3 and the joint scheduled surface of the fourth metallic plate 4. As the mechanical polishing, a method of polishing with a wire brush, for example, is exemplified, but the method is not specifically limited as long as it can mechanically remove a surface oxide layer of the joint scheduled surface. By performing such mechanical polishing (providing a mechanical polishing step), even by the clad rolling at the rolling reduction of, e.g., 25 % to 70 %, joining with sufficient joint strength can be attained.

Further, after the second rolling step but before the subsequent surface activation treatment step, the second laminated plate 22 obtained by the clad rolling can be subjected to a diffusion heat treatment at a heat treatment temperature of 500 °C to 700 °C. By performing such diffusion heat treatment, the joint strength of the third metallic plate 3 and the fourth metallic plate 4 can be improved.

The order of performing the first rolling step and the second rolling step is not specifically limited. The first rolling step can be performed initially, the second rolling step can be performed initially, or the first rolling step and the second rolling step can be performed simultaneously in parallel.

**(Surface Activation Treatment Step)**

After performing both of the first rolling step and the second rolling step, a surface activation treatment step is performed. As shown in Fig. 4, the first supply roll 51 on which the first laminated plate 21 is wound is arranged in the vacuum chamber 49 of the production apparatus 40, and the other second supply roll 52 on which the second laminated plate 22 is wound is arranged in the vacuum chamber 49.

The vacuum chamber 49 is configured so that the interior space can be made into a vacuum state by a not-illustrated vacuum apparatus. In the vacuum chamber 49, the first electrode roll 53, a surface activation treatment apparatus 42A arranged apart from the first electrode roll 53 at a position close to the first electrode roll 53, a second electrode roll 54, a surface activation treatment apparatus 42B arranged apart from the second electrode roll 54 at a position closed to the second electrode roll 54, a pair of pressure rolls 44 and 44, and a wind-up roll 55 are arranged. The surface activation treatment apparatus 42A is configured to perform plasma etching processing of the surface of the metallic plate fitted on the outer peripheral surface of the first electrode roll 53 by applying a high-frequency voltage having a frequency of 10 MHz to 50 MHz between an electrode in the apparatus 42A and the first electrode roll 53 to irradiate plasma onto the surface of the metallic plate. In the same manner, the surface activation treatment apparatus 42B is configured to perform plasma etching processing of the surface of the metallic plate fitted on the outer peripheral surface of the second electrode roll 54 by applying a high-frequency voltage having a frequency of 10 MHz to 50 MHz between an electrode in the apparatus 42B and the second electrode roll 54 to irradiate plasma onto the surface of the metallic plate.

Next, the inside of the vacuum chamber 49 is maintained in a vacuum state. It is preferable that the degree of vacuum in the vacuum chamber 49 is set to $1 \times 10^{-4}$ Pa to 1 Pa. Further, it is also preferable that the inside of the vacuum chamber 49 is filled with inert gas such as nitrogen, argon, etc. , into an inert gas atmosphere and then the degree of vacuum is set to $1 \times 10^{-4}$ Pa to 1 Pa by raising the degree of vacuum.

In the vacuum chamber 49 which is in a vacuum state, the first laminated plate 21 unwound from the first supply roll 51 is brought into contact with the outer peripheral surface of the first electrode roll 53 along the outer peripheral surface, plasma is irradiated from the surface activation treatment apparatus 42A onto the surface of the second metallic plate (e.g., titanium plate) 2 of the first laminated plate 21 in contact with the first electrode roll 53, and thereafter the laminated plate 21 is fed between the pair of pressure rolls 44 and 44 (see Fig. 4). By the plasma etching processing, it is possible to remove oxides, absorbed substances, etc., on the surface of the second metallic plate (e.g., titanium plate) 2 which is a joint scheduled surface of the first laminated plate 21 and expose the cleaned surface.

Simultaneously, in the vacuum chamber 49 which is in a vacuum state, the second laminated plate 22 unwound from the second supply roll 52 is brought into contact with the outer peripheral surface of the second electrode roll 54 along the outer peripheral surface, plasma is irradiated from the surface activation treatment apparatus 42B onto the surface (joint scheduled surface) of the third metallic plate (e.g., aluminum plate) 3 of the second laminated plate 22 in contact with the second electrode roll 54 to perform plasma etching processing of the third metallic plate (e.g. , aluminum plate) 3, and thereafter the second laminated plate 22 is fed between the pair of pressure rolls 44 and 44 (see Fig. 4). By the plasma etching processing, it is possible to remove oxides, absorbed substances, etc., on the surface of the second metallic plate (e.g., aluminum plate) 3 which is a joint scheduled surface of the second laminated plate 22 and expose the cleaned surface.

**(Cold Pressure Welding Step)**

Subsequently, in the vacuum chamber 49 which is in a vacuum state, the first laminated plate 21 and the second metallic plate 22 (i.e., titanium plate) are superposed so that the surface of the second metallic plate (i.e., titanium plate) 2 which is a joint scheduled surface of the first laminated plate 21 and the surface of the third metallic plate (aluminum plate) 3 which is a joint scheduled surface of the second laminated plate 22 are brought into contact with each other and cold pressure welded by and between the pair of pressure rolls 44 and 44 so that the rolling reduction becomes as low as 0.1 % to 15 % (see Fig. 4).

Then, in the vacuum chamber 49 which is in a vacuum state, the multilayer clad material 10 obtained by the cold pressure welding is wound on the wind-up roll 55 (see Fig. 4).

The obtained multilayer clad material 10 is, as shown in Fig. 2, provided with a four-layer laminated structure in which the first metallic plate (e.g., nickel plate) 1 is laminated on the upper surface of the second metallic plate (e.g., titanium plate) 2, the third metallic plate (e.g., aluminum plate) 3 is laminated on the lower surface of the second metallic plate (e.g., titanium plate) 2, and the fourth metallic plate (e.g., aluminum brazing plate) 4 is laminated on the lower surface of the third metallic plate (e.g., aluminum plate) 3.

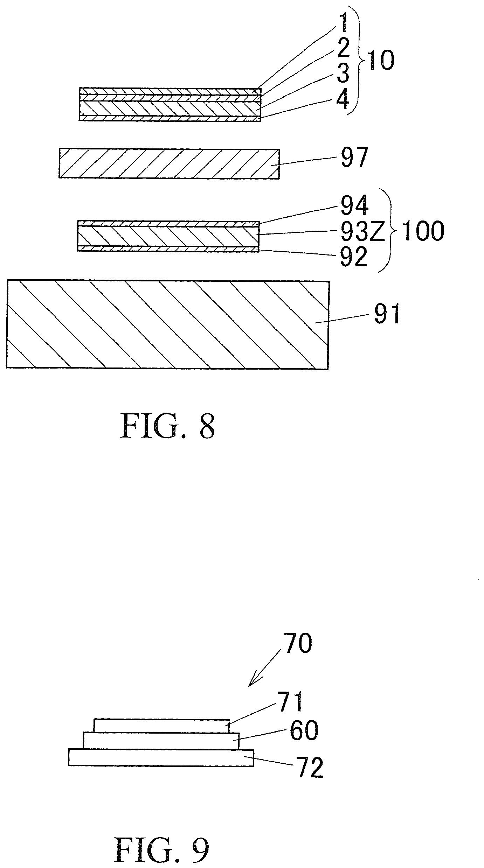

The multilayer clad material 10 having a four-layer laminated structure of the nickel plate 1 / titanium plate 2 / aluminum plate 3 / aluminum brazing plate 4 can be used by being brazed directly to a semiconductor element joining surface side of a DBA substrate (cooler integrated insulating substrate) 95 (see Fig. 7) or by being brazed directly to a ceramic plate 97 (see Fig. 8).

Fig. 7 is a schematic cross-sectional view showing an example of a cooler integrated insulating substrate in an exploded state before lamination. In Fig. 7, the reference symbol "91" denotes an aluminum plate as a heat dissipation member, "92" denotes an aluminum brazing foil, "93" denotes an aluminum punching plate, "94" denotes an aluminum brazing foil, and "95" denotes a DBA (Al layer 96 / AlN layer (aluminum nitride layer) 97 / Al layer 98).

Fig. 8 is a schematic cross-sectional view showing another example of a cooler integrated insulating substrate in an exploded state before lamination. In Fig. 8, the reference symbol "91" denotes an aluminum plate as a heat dissipation member, "100" denotes a clad material (aluminum brazing material 92 / aluminum plate 93Z / aluminum brazing material 94), and "97" denotes a ceramic plate (Aluminum nitride layer layer).

The titanium plate 2 functions as a barrier layer which prevents a brittle alloy layer from being created due to the contact of the nickel plate 1 and the aluminum plate 3. Ti is 21.9 W/m• K in thermal conductivity, and the thermal conductivity is remarkably low as compared with Ni of 90.7 W/m•K, or Al of 236 W/m • K. Therefore, in the use of an insulating substrate which requires high heat dissipation characteristics, it is preferable that the titanium plate 2 is set to be thin, specifically 3 $\mu$m to 30 $\mu$m.

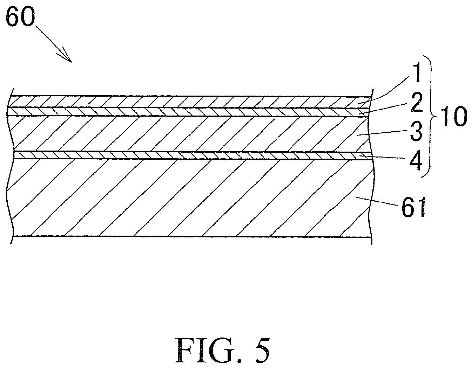

Further, as to the aluminum plate 3, the thickness design differs substantially between the case of joining to a DBA • heat sink • cooler and the case of using as a wiring layer by directly joining to a ceramic plate. In cases where the aluminum plate is joined directly to a ceramic plate 61 and used as a wiring layer (see Fig. 5), it is preferable that the thickness of the aluminum plate 3 of the multilayer clad material 10 having a four-layer laminated structure is set to 200 $\mu$m to 800 $\mu$m to control increase of electric resistance. On the other hand, in cases where the aluminum plate is used as a use of brazing to a DBA plate, in order to prevent the contact of the Ti layer 2 and the brazing layer 4 at the time of brazing, it is preferable that the thickness of the aluminum plate 3 in the multilayer clad material 10 having a four-layer laminated structure is 40 $\mu$m or more.

In the aforementioned cold pressure welding step, the rolling reduction is set to 0.1 % to 15 %. By setting the rolling reduction to the range, it is possible to further improve the flatness of the joint interface of the third metallic plate and the second metallic plate, and also possible to obtain a multilayer clad material 10 in which no alloy layer is formed at the joint interface of the third metallic plate and the second metallic plate and the thickness of the thinner metallic plate is controlled with a higher degree of accuracy. When the rolling reduction is less than 0.1 %, a sufficient joint strength cannot be obtained between the third metallic plate and the second metallic plate. Further, when the rolling reduction exceeds 15 %, there arise problems that the flatness of the joint interface cannot be obtained and cracks occur at the joint interface in the case of a combined metallic material forming a brittle alloy layer. Among other things, it is preferable that the rolling reduction is set to 0.1 % to 10 %, more preferably 0.1 % to 5.0 %.

The "rolling reduction" is a value obtained by the following calculation formula:

$$\text{rolling reduction (\%)} = \{(X - Y) \ / \ X\} \times 100,$$

where "X" ($\mu$m) is a total thickness (the total of the thickness of the first laminated plate and the thickness of the second laminated plate) of the metallic plates to be subjected to a cold pressure welding before being cold press welded by and between the pressure rolls 44 and 44, and "Y" ($\mu$m) is a thickness of the multilayer clad material 10 obtained by the clad rolling.

It is preferable that the temperature of the pressure rolls 44 at the time of executing the cold pressure welding in the cold pressure welding step is set within a range of 10 °C to 80 °C. In this case, it is possible to obtain a multilayer clad material 10 in which the thickness of the thinner metallic plate is controlled with a higher degree of accuracy.

In the second production method, like Example 3 which will be explained later, the first metallic plate, second metallic plate, third metallic plate and fourth metallic plate are structured such that these four plates are made of dissimilar metallic materials, which is a major example but not limited to it.

According to the aforementioned second production method, the surface activation treatment is executed before the cold pressure welding and therefore oxides, absorbed substances, etc., on the joint scheduled surfaces are removed by the surface activation treatment to expose the cleaned surfaces, in the following cold pressure welding step, sufficient joint strength can be secured even at a low rolling reduction (0.1 % to 15 %). Therefore, in the second production method, no diffusion heat treatment (to improve the joint strength) is required after the cold pressure welding step, and therefore a diffusion heat treatment (normally, a heat treatment at 300 °C or above) is not executed after the cold pressure welding step. Therefore, according to the second production method, even in the case of using a wide width material, a multilayer clad material with no curve can be obtained.

**[First and Second Production Methods]**

In the production methods according to the present invention, the first metallic plate, second metallic plate and third metallic plate are a nickel plate, a titanium plate, an aluminum. Further, the fourth metallic plate is an aluminum brazing plate.

In the production method of the present invention, by adding other steps other than the aforementioned steps, a multilayer clad material having a five-layer laminated structure, a six-layer laminated structure, or a seven or more layer laminated structure can be produced, and it should be noted that the production method of the present invention includes such production methods.

An example of a semiconductor module 70 produced by using the multilayer clad material 10 produced by the production method of the present invention as a part of the constituent material is shown in Fig. 9. In this semiconductor module 70, a semiconductor element 71 is joined on the upper surface of the nickel layer (nickel plate) 1 of the insulating substrate 60 having the structure shown in Fig. 5, and the heat dissipation member 72 is joined to the lower surface of the ceramic layer 61 of the insulating substrate 60. The semiconductor element 71 is joined to the nickel layer 1 of the insulating substrate 60 by soldering.

As the semiconductor element 71, it is not specifically limited, but for example, an IGBT chip, a MOSFET chip, a thyristor chip, a diode chip, etc., can be exemplified. As the heat dissipation member 72, it is not specifically limited, but, for example, a heat sink, a cooler, etc., can be exemplified.

The insulating substrate 60 is to transfer the heat generated from the semiconductor element 71 in accordance with the operation of the semiconductor element 71 to the heat dissipation member 72, and is a conductor thermally but functions as an insulating material electrically.

**EXAMPLES**

Next, concrete examples of the present invention will be explained, but it should be understood that the present invention is not limited to these examples.

**<Example 1>**

After polishing the joint scheduled surfaces of a nickel plate 1 having a thickness of 60 $\mu$m and a titanium plate 2 having a thickness of 40 $\mu$m with a wire brush, the nickel plate 1 and the titanium plate 2 were superposed and cold clad rolled (the temperature of the reduction roll: 25 °C) at a rolling reduction of 50 %, to thereby obtain a laminated plate 20 having a thickness of 50 $\mu$m and a width of 200 mm in which the nickel plate 1 and the titanium plate 2 were laminated (Rolling Step). Then, the laminated plate 20 was subjected to a diffusion heat treatment at 600 °C.

Using the apparatus 40 shown in Fig. 3, in the vacuum chamber 49 set to 1 x 10$^{-3}$ Pa, plasma was irradiated to the surface (joint scheduled surface) of the titanium plate 2 of the laminated plate 20 and the surface (joint scheduled surface) of the aluminum plate 3 having a thickness of 85 $\mu$m and a width of 200 mm, to thereby execute plasma etching processing of these surfaces (Surface Activation Treatment Step).

Subsequently, as shown in Fig. 3, in the vacuum chamber 49 set to 1 x 10$^{-3}$ Pa, the laminated plate 20 and the aluminum plate 3 were superposed so that the surface (etching processed surface) of the titanium plate 2 of the laminated plate 20 and the surface (etching processed surface) of the aluminum plate 3 were brought into contact with each other, and both these plates were cold pressure welded by and between a pair of pressure rolls 44 and 44 at 25 °C (room temperature), to thereby obtain a multilayer clad material 10 having a thickness of 130 $\mu$m and a width of 200 mm (Cold Pressure Welding Step).

The obtained multilayer clad material 10 has, as shown in Fig. 1, a three-layer laminated structure in which a nickel plate 1 having a thickness of 30 $\mu$m, a titanium plate 2 having a thickness of 20 $\mu$m, and an aluminum plate 3 having a thickness of 80 $\mu$m were integrally laminated in this order. Therefore, the rolling reduction in the cold pressure welding step was

$$100 \times \{(50 + 85) - 130\} / (50 + 85) = 3.7$$

The rolling reduction was 3.7 % from the above calculation formula.

**<Example 2>**

After polishing the joint scheduled surfaces of a nickel plate 1 having a thickness of 60 $\mu$m and a titanium plate 2 having a thickness of 40 $\mu$m with a wire brush, the nickel plate 1 and the titanium plate 2 were superposed and cold clad rolled (the temperature of the reduction roll: 25 °C) at a rolling reduction of 50 %, to thereby obtain a laminated plate 20 having a thickness of 50 $\mu$m and a width of 200 mm in which the nickel plate 1 and the titanium plate 2 were laminated (Rolling Step). Then, the laminated plate 20 was subjected to a diffusion heat treatment at 600 °C.

Using the apparatus 40 shown in Fig. 3, in the vacuum chamber 49 set to 1 x 10$^{-3}$ Pa, plasma was irradiated to the surface (joint scheduled surface) of the titanium plate 2 of the laminated plate 20 and the surface (joint scheduled surface) of the aluminum plate 3 having a thickness of 610 $\mu$m and a width of 200 mm, to thereby execute plasma etching processing of these surfaces (Surface Activation Treatment Step).

Subsequently, as shown in Fig. 3, in the vacuum chamber 49 set to 1 x 10$^{-3}$ Pa, the laminated plate 20 and the aluminum plate 3 were superposed so that the surface (etching processed surface) of the titanium plate 2 of the laminated plate 20 and the surface (etching processed surface) of the aluminum plate 3 were brought into contact with each other, and both these plates were cold pressure welded by and between a pair of pressure rolls 44 and 44 at 25 °C (room temperature), to thereby obtain a multilayer clad material 10 having a thickness of 650 $\mu$m and a width of 200 mm (Cold Pressure Welding Step).

The obtained multilayer clad material 10 has, as shown in Fig. 1, a three-layer laminated structure in which a nickel plate 1 having a thickness of 30 μm, a titanium plate 2 having a thickness of 20 μm, and an aluminum plate 3 having a thickness of 600 μm were integrally laminated in this order. Therefore, the rolling reduction in the cold pressure welding step was

$$100 \times \{(50 + 610) - 650\} / (50 + 610) = 1.5$$

The rolling reduction was 1.5 % from the above calculation formula.

<Example 3>

After polishing the joint scheduled surfaces of a nickel plate 1 having a thickness of 60 μm and a titanium plate 2 having a thickness of 40 μm with a wire brush, the nickel plate 1 and the titanium plate 2 were superposed and cold clad rolled (the temperature of the reduction roll: 25 °C) at a rolling reduction of 50 %, to thereby obtain a first laminated plate 21 having a thickness of 50 μm and a width of 200 mm in which the nickel plate 1 and the titanium plate 2 were laminated (First Rolling Step). Then, the first laminated plate 21 was subjected to a diffusion heat treatment at 600 °C.
After polishing the joint scheduled surfaces of an aluminum plate 3 having a thickness of 180 μm and an aluminum brazing plate (Al-si alloy plate in which the Si content rate was 10 mass% and the Al content rate was 90 mass%) 4 having a thickness of 50 μm with a wire brush, the aluminum plate 3 and the aluminum plate 4 were superposed and clad rolled (the temperature of the reduction roll: 25 °C) at a rolling reduction of 54 %, to thereby obtain a second laminated plate 22 having a thickness of 105 μm and a width of 200 mm in which the aluminum plate 3 and the aluminum plate 4 were laminated (Second Rolling Step).
Using the apparatus 40 shown in Fig. 4, in the vacuum chamber 49 set to 1 x $10^{-3}$ Pa, plasma was irradiated to the surface (joint scheduled surface) of the titanium plate 2 of the first laminated plate 21 and the surface (joint scheduled surface) of the aluminum plate 3 of the second laminated plate 22, to thereby execute plasma etching processing of these surfaces (Surface Activation Treatment Step).
Subsequently, as shown in Fig. 4, in the vacuum chamber 49 set to 1 x $10^{-3}$ Pa, the first laminated plate 21 and the second laminated plate 22 were superposed so that the surface (etching processed surface) of the titanium plate 2 of the first laminated plate 21 and the surface (etching processed surface) of the aluminum plate 3 of the second laminated plate 22 were brought into contact with each other, and both these plates were cold pressure welded by and between a pair of pressure rolls 44 and 44 at 25 °C (room temperature), to thereby obtain a multilayer clad material 10 having a thickness of 150 μm and a width of 200 mm (Cold Pressure Welding Step).
The obtained multilayer clad material 10 has, as shown in Fig. 2, a four-layer laminated structure in which a nickel plate 1 having a thickness of 30 μm, a titanium plate 2 having a thickness of 20 μm, an aluminum plate 3 having a thickness of 80 μm, and an aluminum brazing plate 4 having a thickness of 20 μm were integrally laminated in this order. Therefore, the rolling reduction in the cold pressure welding step was

$$100 \times \{(50 + 105) - 150\} / (50 + 105) = 3.2$$

The rolling reduction was 3.2 % from the above calculation formula.

<Example 4>

After polishing the joint scheduled surfaces of a nickel plate 1 having a thickness of 60 μm and a titanium plate 2 having a thickness of 40 μm with a wire brush, the nickel plate 1 and the titanium plate 2 were superposed and cold clad rolled (the temperature of the reduction roll: 25 °C) at a rolling reduction of 50 %, to thereby obtain a first laminated plate 21 having a thickness of 50 μm and a width of 200 mm in which the nickel plate 1 and the titanium plate 2 were laminated (First Rolling Step). Then, the first laminated plate 21 was subjected to a diffusion heat treatment at 600 °C.
After polishing the joint scheduled surfaces of an aluminum plate 3 having a thickness of 1,400 μm and an aluminum brazing plate (Al-si alloy plate in which the Si content rate was 10 mass% and the Al content rate was 90 mass%) 4 having a thickness of 50 μm with a wire brush, the aluminum plate 3 and the aluminum brazing plate 4 were superposed and cold clad rolled (the temperature of the reduction roll: 25 °C) at a rolling reduction of 57 %, to thereby obtain a second laminated plate 22 having a thickness of 630 μm and a width of 200 mm in which the aluminum plate 3 and the aluminum plate 4 were laminated (Second Rolling Step).
Using the apparatus 40 shown in Fig. 4, in the vacuum chamber 49 set to 1 x $10^{-3}$ Pa, plasma was irradiated to the surface (joint scheduled surface) of the titanium plate 2 of the first laminated plate 21 and the surface (joint scheduled surface) of the aluminum plate 3 of the second laminated plate 22, to thereby execute plasma etching processing of these surfaces (Surface Activation Treatment Step).

Subsequently, as shown in Fig. 4, in the vacuum chamber 49 set to 1 x 10^{-3} Pa, the first laminated plate 21 and the second laminated plate 22 were superposed so that the surface (etching processed surface) of the titanium plate 2 of the first laminated plate 21 and the surface (etching processed surface) of the aluminum plate 3 of the second laminated plate 22 were brought into contact with each other, and both these plates were cold pressure welded by and between a pair of pressure rolls 44 and 44 at 25 °C (room temperature), to thereby obtain a multilayer clad material 10 having a thickness of 670 μm and a width of 200 mm (Cold Pressure Welding Step).

The obtained multilayer clad material 10 has, as shown in Fig. 2, a four-layer laminated structure in which a nickel plate 1 having a thickness of 30 μm, a titanium plate 2 having a thickness of 20 μm, an aluminum plate 3 having a thickness of 600 μm, and an aluminum brazing plate 4 having a thickness of 20 μm were integrally laminated in this order. Therefore, the rolling reduction in the cold pressure welding step was

$$100 \times \{(50 + 630) - 670\} / (50 + 630) = 1.5$$

The rolling reduction is 1.5 % from the above calculation formula.

**<Comparative Example 1>**

After polishing the joint scheduled surfaces of a nickel plate having a thickness of 120 μm and a titanium plate having a thickness of 80 μm with a wire brush, the nickel plate and the titanium plate were superposed and cold clad rolled (the temperature of the reduction roll: 25 °C) at a rolling reduction of 50 %, to thereby obtain a laminated plate having a thickness of 100 μm and a width of 200 mm in which the nickel plate and the titanium plate were laminated (First Rolling Step). Then, the laminated plate was subjected to a diffusion heat treatment at 600 °C.

Then, after polishing a surface (joint scheduled surface) of a titanium plate of the laminated plate and a surface (joint scheduled surface) of an aluminum plate having a thickness of 160 μm and a width of 200 μm with a wire brush, the laminated plate and the aluminum plate were superposed and cold clad rolled (the temperature of the reduction roll: 25 °C) at a rolling reduction of 50 %, to thereby obtain a multilayer clad material 10 of a three-layer laminated plate (Second Rolling Step).

Next, in order to improve the joint strength of the joint interface, a diffusion heat treatment was performed at 300 °C for 10 minutes, but there occurred curves and undulations in the laminated plate because of the wide width of 200 mm, which made it difficult to roll up on the wind-up roll (no actual production could be performed).

**<Comparative Example 2>**

After polishing the joint scheduled surfaces of a nickel plate having a thickness of 120 μm and a titanium plate having a thickness of 80 μm with a wire brush, the nickel plate and the titanium plate were superposed and cold clad rolled (the temperature of the reduction roll: 25 °C) at a rolling reduction of 50 %, to thereby obtain a laminated plate having a thickness of 100 μm and a width of 30 mm in which the nickel plate and the titanium plate were laminated (First Rolling Step). Then, the laminated plate was subjected to a diffusion heat treatment at 600 °C.

Then, after polishing a surface (joint scheduled surface) of a titanium plate of the laminated plate (width 30 mm) and a surface (joint scheduled surface) of an aluminum plate having a thickness of 600 μm and a width of 30 mm with a wire brush, the laminated plate and the aluminum plate were superposed and cold clad rolled (the temperature of the reduction roll: 25 °C) at a rolling reduction of 50 %, to thereby obtain a multilayer clad material 10 of a three-layer laminated clad material (Second Rolling Step).

The cross-section of the obtained multilayer clad material was observed with an electron microscope, and the observation found that the titanium plate (titanium layer) was broken.

**<Comparative Example 3>**

After polishing the joint scheduled surfaces of a nickel plate having a thickness of 60 μm and a titanium plate having a thickness of 40 μm with a wire brush, the nickel plate and the titanium plate were superposed and cold clad rolled (the temperature of the reduction roll: 25 °C) at a rolling reduction of 50 %, to thereby obtain a laminated plate having a thickness of 50 μm and a width of 200 mm in which the nickel plate and the titanium plate were laminated (First Rolling Step). Then, the laminated plate was subjected to a diffusion heat treatment at 600 °C.

Then, after polishing a surface (joint scheduled surface) of a titanium plate of the laminated plate and a surface (joint scheduled surface) of an aluminum plate having a thickness of 133 $\mu$m and a width of 200 mm with a wire brush, the laminated plate and the aluminum plate were superposed and cold clad rolled (the temperature of the reduction roll: 25 °C) at a rolling reduction of 2 % (Second Rolling Step), to try to obtain a multilayer clad material, but the laminated plate and the aluminum plate could not be joined.

**<Comparative Example 4>**

A production of a multilayer clad material was attempted in the same manner as in Example 1 except that the rolling reduction in the cold pressure welding step was set so as to become 0.05 %, but the laminated plate and the aluminum plate were not joined.

**<Comparative Example 5>**

A multilayer clad material having a thickness of 130 $\mu$m and a width of 200 mm was obtained in the same manner as in Example 1 except that the rolling reduction in the cold pressure welding step was set so as to become 25 %.
On each multilayer clad material obtained as mentioned above, evaluation was performed based on the following evaluation method. These evaluation results are shown in Table 1.

**<Evaluation Method for Presence of Generation of Curves and Undulations in Multilayer Clad Material>**

Presence of curves and undulations on the surface (Ni layer surface) of the obtained multilayer clad material was examined using a laser type shape measuring instrument.

**<Evaluation Method for Presence of Generation of Breakages of Each Constituent Layer of Multilayer Clad Material>**

The cross-section of the obtained multilayer clad material was observed with an electron microscope, and the presence of breakages in each constituent layer was examined.

[Table 1]

| | | Joining method | | Cold Pressure Welding Step | | | Obtained Multilayer clad material | |
|---|---|---|---|---|---|---|---|---|
| | | Joining method to obtain a two-layer laminated plate | Joining method to obtain a multilayer clad material using the two-layer laminated plate obtained by the left method | Thickness ($\mu$m) | | Rolling reduction (%) | Presence of occurrence of curves, undulations | Presence of breakages of constituent layer |
| | | | | X | Y | | | |
| Ex. 1 | | Clad rolling | Cold pressure welding | 135 | 130 | 3.7 | Nil | Nil |
| Ex. 2 | | Clad rolling | Cold pressure welding | 660 | 650 | 1.5 | Nil | Nil |
| Ex. 3 | | Clad rolling | Cold pressure welding | 155 | 150 | 3.2 | Nil | Nil |
| Ex. 4 | | Clad rolling | Cold pressure welding | 680 | 670 | 1.5 | Nil | Nil |
| Comp. Ex. 1 | | First clad rolling | Second clad rolling | | | | Occurred remarkably | Nil |
| Comp. Ex. 2 | | First clad rolling | Second clad rolling | | | | Nil | Ti layer broken |
| Comp. Ex. 3 | | First clad rolling | Second clad rolling | | | | (could not be joined) | |
| Comp. Ex. 4 | | Clad rolling | Cold pressure welding | 130.07 | (130) | 0.05 | (Good joint could not be attained) | |

(continued)

| | Joining method | | Cold Pressure Welding Step | | | Obtained Multilayer clad material | |
|---|---|---|---|---|---|---|---|
| | Joining method to obtain a two-layer laminated plate | Joining method to obtain a multilayer clad material using the two-layer laminated plate obtained by the left method | Thickness ($\mu$m) | | Rolling reduction (%) | Presence of occurrence of curves, undulations | Presence of breakages of constituent layer |
| | | | X | Y | | | |
| Comp. Ex. 5 | Clad rolling | Cold pressure welding | 174 | 130 | 25 | (Cracks generated in alloy portion of joint interface) | |

X: Total thickness ($\mu$m) of a metallic plate to be pressure welded before cold pressure welding
Y: Thickness ($\mu$m) of multilayer clad material obtained by cold pressure welding

As will be apparent from Table 1, in the multilayer clad materials of Examples 1 to 4 produced by a production method of the present invention, the thickness of one of metallic plates to be laminated in the cold pressure welding differs significantly from the thickness of the other metallic plate (over 2.0 times or less than 0.5 times). Nevertheless, the thickness of the thinner metallic plate was controlled with a high degree of accuracy, and that no curves or undulations were generated and no breakage of constituent layer occurred. Further, in the multilayer clad material of Examples 1 to 4, although the width was as wide as 200 mm, no curve or undulation occurred.

On the other hand, in Comparative Example 1, curves and undulations were generated by the diffusion heat treatment to improve the joint strength of the joint interface, it was difficult to roll up the clad material, which prevented an actual production. Further, in Comparative Example 2, in the second rolling step, since the difference between the thicknesses of plates to be superposed was significant (one was 100 $\mu$m, and the other was 600 $\mu$m), the thinner titanium layer (titanium plate) was broken. In Comparative Example 3, in the second rolling step, since the cold clad rolling was performed at the rolling reduction of 2 %, the laminated plate and the aluminum plate could not be joined.

Further, in Comparative Example 4, since the rolling reduction in the cold pressure welding was smaller than the range defined by the present invention, the laminated plate and the aluminum plate could not be joined in a good manner. Further, in Comparative Example 5, since the rolling reduction in the cold pressure welding step was larger than the range defied by the present invention, cracks were generated in the interface of the laminated plate and the aluminum plate.

## INDUSTRIAL APPLICABILITY

The multilayer clad material produced by the production method of a multilayer clad material according to the present invention can be preferably used as, for example, a multilayered material for insulating substrates to release heat of a semiconductor element, but not limited to it. The multilayer clad material produced by the production method of the present invention is used as a part of a constituent material to produce, for example, an insulating substrate, a semiconductor module, etc.

## DESCRIPTION OF THE REFERENCE NUMERALS

1...first metallic plate
2...second metallic plate
3...third metallic plate
4...fourth metallic plate
10...multilayer clad material
20...laminated plate
21...first laminated plate
22...second laminated plate
40...apparatus
42A, 42B...surface activation treatment apparatus
44...pressure roll

49...vacuum chamber

**Claims**

1. A production method of a multilayer clad (10) material for electrically insulating substrates, comprising:

   a rolling step of obtaining a laminated plate (20) by cold clad rolling a nickel plate or nickel alloy plate (1) and a titanium plate or titanium alloy plate (2) in a superposed manner at a rolling reduction of 25 % to 85 %;
   a surface treatment step of subjecting at least a surface of the titanium plate or titanium alloy plate of the laminated plate and at least a joint scheduled surface of an aluminum plate or aluminium alloy plate (3) to a surface treatment in vacuum so as to remove oxides and absorbed substances, wherein the surface treatment is plasma etching processing; and
   a cold pressure welding step of, after performing the surface treatment, in vacuum, cold pressure welding the laminated plate and the aluminum plate or aluminium alloy plate by and between a pair of pressure rolls so that a rolling reduction becomes 0.1 % to 15 % in a superposed manner that the surface of the titanium plate or titanium alloy plate of the laminated plate and a joint scheduled surface of the aluminum plate or aluminium alloy plate are in contact with each other.

2. The production method of a multilayer clad material as recited in claim 1, wherein
   a thickness of the nickel plate or nickel alloy plate is 0.5 to 2.0 times a thickness of the titanium plate or titanium alloy plate, and
   a thickness of the aluminum plate or aluminium alloy plate is over 2.0 times or less than 0.5 times a thickness of the titanium plate or titanium alloy plate.

3. The production method of a multilayer clad material as recited in claim 1, wherein
   a thickness of the nickel plate or nickel alloy plate is 10 to 100 $\mu$m,
   a thickness of the titanium plate or titanium alloy plate is 5 to 30 $\mu$m, and
   a thickness of the aluminum plate or aluminum alloy plate is within a range of over 60 $\mu$m to 10 mm or less.

4. A production method of a multilayer clad material (10) according to any one of claims 1 to 3, further comprising
   a second rolling step of obtaining a second laminated plate (22) by cold clad rolling an aluminum plate or aluminum alloy plate and a brazing plate (4) in a superposed manner at a rolling reduction of 25 % to 85 %; wherein
   in the surface treatment step at least a surface of the titanium plate or titanium alloy plate of the first laminated plate and at least a surface of the aluminum plate or aluminum alloy plate of the second laminated plate are subjected to a surface treatment in vacuum so as to remove oxides and absorbed substances; and
   in the cold pressure welding step, after performing the surface treatment, in vacuum, cold pressure welding the first laminated plate and the second laminated plate is performed by and between a pair of pressure rolls at a rolling reduction of 0.1 % to 15 % in a superposed manner that a surface of the titanium plate or titanium alloy plate of the first laminated plate and a surface of the aluminum plate or aluminum alloy plate of the second laminated plate are in contact with each other.

5. The production method of the multilayer clad material as recited in claim 4, wherein
   a thickness of the brazing plate is 0.5 to 2.0 times a thickness of the aluminum plate or aluminum alloy plate.

6. The production method of the multilayer clad material as recited in claim 4, wherein a thickness of the brazing plate is 10 $\mu$m to 60 $\mu$m.

7. The production method of the multilayer clad material as recited in any one of claims 1 to 6, wherein
   a temperature of the pressure rolls at a time of the cold pressure welding in the cold pressure welding step is within a range of 10 °C to 80 °C.

8. The production method of the multilayer clad material as recited in any one of claims 1 to 6, wherein
   the rolling reduction of the cold clad rolling in the rolling step is 45 % to 65 %.

9. The production method of the multilayer clad material as recited in claim 1, wherein
   after the rolling step, but before the subsequent surface treatment step, the laminated plate (20) obtained by the clad rolling is subjected to a diffusion heat treatment.

10. The production method of the multilayer clad material as recited in claim 4, wherein
after the first rolling step, but before the subsequent surface treatment step, the first laminated plate (21) obtained by the clad rolling is subjected to a diffusion heat treatment.

11. The production method of the multilayer clad material as recited in claim 4 or claim 10, wherein
after the second rolling step, but before the subsequent surface treatment step, the second laminated plate (22) obtained by the clad rolling is subjected to a diffusion heat treatment.

12. The production method of the multilayer clad material as recited in any one of claims 9 to 11, wherein
the diffusion heat treatment temperature is 500 °C to 700 °C.

**Patentansprüche**

1. Herstellungsverfahren für ein mehrschichtiges Verkleidungsmaterial (10) zum elektrischen Isolieren von Substraten, umfassend:

einen Walzschritt des Erhaltens einer laminierten Platte (20) durch Kaltwalzplattieren einer Nickelplatte oder Nickellegierungsplatte (1) und einer Titanplatte oder Titanlegierungsplatte (2) auf übereinander angeordnete Weise bei einer Walzreduktion von 25 % bis 85 %;
einen Oberflächenbehandlungsschritt des Durchführens einer Oberflächenbehandlung im Vakuum an zumindest einer Oberfläche der Titanplatte oder Titanlegierungsplatte der laminierten Platte und zumindest einer gemeinsam vorgesehenen Oberfläche einer Aluminiumplatte oder Aluminiumlegierungsplatte (3), um Oxide und absorbierte Substanzen zu entfernen, wobei die Oberflächenbehandlung Plasmaätzverarbeitung ist; und
einen Kaltpressschweißschritt des Kaltpressschweißens der laminierten Platte und der Aluminiumplatte oder Aluminiumlegierungsplatte durch und zwischen zwei Presswalzen nach dem Durchführen der Oberflächenbehandlung im Vakuum, sodass eine Walzreduktion 0,1 % bis 15 % auf eine übereinander angeordnete Weise wird, wobei die Oberfläche der Titanplatte oder Titanlegierungsplatte der laminierten Platte und eine gemeinsam vorgesehene Oberfläche der Aluminiumplatte oder Aluminiumlegierungsplatte in Kontakt miteinander sind.

2. Herstellungsverfahren für ein mehrschichtiges Verkleidungsmaterial nach Anspruch 1, wobei
eine Dicke der Nickelplatte oder Nickellegierungsplatte das 0,5- bis 2,0-fache einer Dicke der Titanplatte oder Titanlegierungsplatte beträgt und
eine Dicke der Aluminiumplatte oder Aluminiumlegierungsplatte mehr als das 2,0-fache oder weniger als das 0,5-fache einer Dicke der Titanplatte oder Titanlegierungsplatte beträgt.

3. Herstellungsverfahren für ein mehrschichtiges Verkleidungsmaterial nach Anspruch 1, wobei
eine Dicke der Nickelplatte oder Nickellegierungsplatte 10 bis 100 $\mu$m beträgt,
eine Dicke der Titanplatte oder Titanlegierungsplatte 5 bis 30 $\mu$m beträgt und eine Dicke der Aluminiumplatte oder Aluminiumlegierungsplatte in einem Bereich von über 60 $\mu$m bis 10 mm oder darunter liegt.

4. Herstellungsverfahren für ein mehrschichtiges Verkleidungsmaterial (10) nach einem der Ansprüche 1 bis 3, weiter umfassend
einen zweiten Walzschritt des Erhaltens einer zweiten laminierten Platte (22) durch Kaltwalzplattieren einer Aluminiumplatte oder Aluminiumlegierungsplatte und einer Hartlötplatte (4) auf übereinander angeordnete Weise bei einer Walzreduktion von 25 % bis 85 %; wobei
in dem Oberflächenbehandlungsschritt eine Oberflächenbehandlung im Vakuum zumindest an einer Oberfläche der Titanplatte oder Titanlegierungsplatte der ersten laminierten Platte und zumindest einer Oberfläche der Aluminiumplatte oder Aluminiumlegierungsplatte der zweiten laminierten Platte durchgeführt wird, um Oxide und absorbierte Substanzen zu entfernen; und
in dem Kaltpressschweißschritt nach dem Durchführen der Oberflächenbehandlung im Vakuum ein Kaltpressschweißen der ersten laminierten Platte und der zweiten laminierten Platte durch und zwischen zwei Presswalzen bei einer Walzreduktion 0,1 % bis 15 % auf eine übereinander angeordnete Weise durchgeführt wird, wobei eine Oberfläche der Titanplatte oder Titanlegierungsplatte der ersten laminierten Platte und eine Oberfläche der Aluminiumplatte oder Aluminiumlegierungsplatte der zweiten laminierten Platte in Kontakt miteinander sind.

5. Herstellungsverfahren für das mehrschichtige Verkleidungsmaterial nach Anspruch 4, wobei
eine Dicke der Hartlötplatte das 0,5- bis 2,0-fache einer Dicke der Aluminiumplatte oder Aluminiumlegierungsplatte beträgt.

**6.** Herstellungsverfahren für das mehrschichtige Verkleidungsmaterial nach Anspruch 4, wobei eine Dicke der Hartlötplatte 10 $\mu$m bis 60 $\mu$m beträgt.

**7.** Herstellungsverfahren für das mehrschichtige Verkleidungsmaterial nach einem der Ansprüche 1 bis 6, wobei eine Temperatur der Presswalzen zu einem Zeitpunkt des Kaltpressschweißens im Kaltpressschweißschritt in einem Bereich von 10 °C bis 80 °C liegt.

**8.** Herstellungsverfahren für das mehrschichtige Verkleidungsmaterial nach einem der Ansprüche 1 bis 6, wobei die Walzreduktion des Kaltwalzplattierens im Walzschritt 45 % bis 65 % beträgt.

**9.** Herstellungsverfahren für das mehrschichtige Verkleidungsmaterial nach Anspruch 1, wobei nach dem Walzschritt, aber vor dem anschließenden Oberflächenbehandlungsschritt, eine Diffusionswärmebehandlung an der durch das Kaltwalzen erhaltenen laminierten Platte (20) durchgeführt wird.

**10.** Herstellungsverfahren für das mehrschichtige Verkleidungsmaterial nach Anspruch 4, wobei nach dem ersten Walzschritt, aber vor dem anschließenden Oberflächenbehandlungsschritt, eine Diffusionswärmebehandlung an der durch das Kaltwalzen erhaltenen ersten laminierten Platte (21) durchgeführt wird.

**11.** Herstellungsverfahren für das mehrschichtige Verkleidungsmaterial nach Anspruch 4 oder Anspruch 10, wobei nach dem zweiten Walzschritt, aber vor dem anschließenden Oberflächenbehandlungsschritt, eine Diffusionswärmebehandlung an der durch das Kaltwalzen erhaltenen zweiten laminierten Platte (22) durchgeführt wird.

**12.** Herstellungsverfahren für das mehrschichtige Verkleidungsmaterial nach einem der Ansprüche 9 bis 11, wobei die Temperatur der Diffusionswärmebehandlung 500 °C bis 700 °C beträgt.

**Revendications**

**1.** Procédé de fabrication d'un matériau plaqué multicouche (10) pour substrats électriquement isolants, comprenant :

une étape de laminage pour obtenir une plaque laminée (20) par laminage placage à froid d'une plaque de nickel ou d'une plaque d'alliage de nickel (1) et d'une plaque de titane ou d'une plaque d'alliage de titane (2) de manière superposée à une réduction de laminage de 25 % à 85 % ;
une étape de traitement de surface pour soumettre au moins une surface de la plaque de titane ou de la plaque d'alliage de titane de la plaque laminée et au moins une surface de jointure prévue d'une plaque d'aluminium ou d'une plaque d'alliage d'aluminium (3) à un traitement de surface sous vide de manière à éliminer des oxydes et des substances absorbées, dans lequel le traitement de surface est un traitement de gravure par plasma ; et
une étape de soudure sous pression à froid, après avoir effectué le traitement de surface, sous vide, pour souder sous pression à froid la plaque laminée et la plaque d'aluminium ou la plaque d'alliage d'aluminium par et entre une paire de rouleaux presseurs de sorte qu'une réduction de laminage soit de 0,1 % à 15 % de manière superposée pour que la surface de la plaque de titane ou de la plaque d'alliage de titane de la plaque laminée et une surface de jointure prévue de la plaque d'aluminium ou de la plaque d'alliage d'aluminium soient en contact l'une avec l'autre.

**2.** Procédé de fabrication d'un matériau plaqué multicouche selon la revendication 1, dans lequel une épaisseur de la plaque de nickel ou de la plaque d'alliage de nickel est de 0,5 à 2,0 fois une épaisseur de la plaque de titane ou d'alliage de titane, et
une épaisseur de la plaque d'aluminium ou de la plaque d'alliage d'aluminium est supérieure à 2,0 fois ou inférieure à 0,5 fois une épaisseur de la plaque de titane ou de la plaque d'alliage de titane.

**3.** Procédé de fabrication d'un matériau plaqué multicouche selon la revendication 1, dans lequel une épaisseur de la plaque de nickel ou de la plaque d'alliage de nickel est de 10 à 100 $\mu$m),
une épaisseur de la plaque de titane ou de la plaque d'alliage de titane est de 5 à 30 $\mu$m, et
une épaisseur de la plaque d'aluminium ou de la plaque d'alliage d'aluminium se situe dans une plage allant de plus de 60 $\mu$m à 10 mm ou moins.

**4.** Procédé de fabrication d'un matériau plaqué multicouche (10) selon l'une quelconque des revendications 1 à 3, comprenant en outre

une seconde étape de laminage pour obtenir une seconde plaque laminée (22) par laminage placage à froid d'une plaque d'aluminium ou d'une plaque d'alliage d'aluminium et d'une plaque de brasage (4) de manière superposée à une réduction de laminage de 25 % à 85 % ; dans lequel

dans l'étape de traitement de surface au moins une surface de la plaque de titane ou de la plaque d'alliage de titane de la première plaque laminée et au moins une surface de la plaque d'aluminium ou de la plaque d'alliage d'aluminium de la seconde plaque laminée sont soumises à un traitement de surface sous vide pour éliminer les oxydes et les substances absorbées ; et

dans l'étape de soudage sous pression à froid, après avoir effectué le traitement de surface, sous vide, le soudage sous pression à froid de la première plaque laminée et de la seconde plaque laminée est effectué par et entre une paire de rouleaux presseurs à une réduction de laminage de 0,1 % à 15 % de manière superposée pour qu'une surface de la plaque de titane ou de la plaque d'alliage de titane de la première plaque laminée et une surface de la plaque d'aluminium ou de la plaque d'alliage d'aluminium de la seconde plaque laminée soient en contact l'une avec l'autre.

**5.** Procédé de fabrication du matériau plaqué multicouche selon la revendication 4, dans lequel une épaisseur de la plaque de brasage est de 0,5 à 2,0 fois une épaisseur de la plaque d'aluminium ou de la plaque d'alliage d'aluminium.

**6.** Procédé de fabrication du matériau plaqué multicouche selon la revendication 4, dans lequel une épaisseur de la plaque de brasage est de 10 $\mu$m à 60 $\mu$m.

**7.** Procédé de fabrication du matériau plaqué multicouche selon l'une quelconque des revendications 1 à 6, dans lequel une température des rouleaux presseurs au moment du soudage sous pression à froid dans l'étape de soudage par pression à froid se situe dans une plage allant de 10 °C à 80 °C.

**8.** Procédé de fabrication du matériau plaqué multicouche selon l'une quelconque des revendications 1 à 6, dans lequel la réduction par laminage du laminage placage à froid dans l'étape de laminage est de 45 % à 65 %.

**9.** Procédé de fabrication du matériau plaqué multicouche selon la revendication 1, dans lequel après l'étape de laminage, mais avant l'étape ultérieure de traitement de surface, la plaque laminée (20) obtenue par le laminage placage est soumise à un traitement thermique de diffusion.

**10.** Procédé de fabrication du matériau plaqué multicouche selon la revendication 4, dans lequel après la première étape de laminage, mais avant l'étape ultérieure de traitement de surface, la première plaque laminée (21) obtenue par le laminage placage est soumise à un traitement thermique de diffusion.

**11.** Procédé de fabrication du matériau plaqué multicouche selon la revendication 4 ou la revendication 10, dans lequel après la seconde étape de laminage, mais avant l'étape ultérieure de traitement de surface, la seconde plaque laminée (22) obtenue par le laminage placage est soumise à traitement thermique de diffusion.

**12.** Procédé de production du matériau plaqué multicouche selon l'une quelconque des revendications 9 à 11, dans lequel la température de traitement thermique de diffusion est de 500 °C à 700 °C.

FIG. 1

FIG. 2

FIG. 3

FIG. 4

60

1
2
3
4
} 10

61

# FIG. 5

EP 2 803 480 B1

FIG. 6

FIG. 7

24

FIG. 8

FIG. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004328012 A
- JP 2004235503 A
- JP 2006303346 A
- JP 2009147123 A
- JP 2012004534 A
- US 4896813 A